**Europäisches Patentamt**

(19) **European Patent Office**

**Office européen des brevets**

(11) Veröffentlichungsnummer: **0 048 862**
**B1**

(12) **EUROPÄISCHE PATENTSCHRIFT**

(45) Veröffentlichungstag der Patentschrift:
**20.03.85**

(21) Anmeldenummer: **81107151.3**

(22) Anmeldetag: **10.09.81**

(51) Int. Cl.⁴: **G 01 R 31/26,** G 01 R 27/00

(54) Verfahren zur Messung von Widerständen und Kapazitäten von elektronischen Bauelementen.

(30) Priorität: **29.09.80 DE 3036734**

(43) Veröffentlichungstag der Anmeldung:
**07.04.82 Patentblatt 82/14**

(45) Bekanntmachung des Hinweises auf die Patenterteilung:
**20.03.85 Patentblatt 85/12**

(84) Benannte Vertragsstaaten:
**DE FR GB NL**

(56) Entgegenhaltungen:
**DE - A - 2 137 619**
**DE - B - 2 215 179**

**SCANNING ELECTRON MICROSCOPY, 1979, H.P. FEUERBAUM "VLSI Testing using the electron probe",**
**Seiten 285-296**

(73) Patentinhaber: **Siemens Aktiengesellschaft, Berlin und München Wittelsbacherplatz 2, D-8000 München 2 (DE)**

(72) Erfinder: **Feuerbaum, Hans-Peter, Dipl.-Phys., Tucholskystrasse 22, D-8000 München 83 (DE)**
Erfinder: **Knauer, Ulrich, Dipl.-Phys., Pfeuferstrasse 30, D-8000 München 70 (DE)**

**Beschreibung**

Die Erfindung betrifft ein Verfahren zur Messung von Widerständen und Kapazitäten von elektronischen Bauelementen gemäss dem Oberbegriff des Anspruchs 1.

Nach dem Stand der Technik wurden Widerstand und Kapazität eines elektronischen Bauelementes dadurch gemessen, dass gleichzeitig zwei Messspitzen aufgesetzt worden sind und dass dem elektronischen Bauelement ein definierter Strom eingeprägt worden ist. Der Nachteil eines solchen Messverfahrens ist, dass eine Messspitze eine nicht zu vernachlässigende Eigenkapazität besitzt, wobei diese Eigenkapazitäten der Messspitzen die Messgenauigkeit des Messverfahrens verringern und den Messbereich verkleinern. Die kleinste nach diesem Verfahren messbare Kapazität beträgt 1 pF.

Aus der deutschen Patentschrift DE-B2-2 215 179 ist ein Verfahren zur Messung von Widerständen von elektrischen Bauelementen bekannt, wobei ein Elektronenstrahl auf ein erstes Ende eines zu messenden Widerstandes auftrifft. Dadurch wird ein Gleichstrom erzeugt, der durch den zu messenden Widerstand fliesst. Aus der von diesem Strom verursachten Potentialänderung am zweiten Ende des zu messenden Widerstandes lässt sich bei bekantem Gleichstrom der zu messende Widerstand bestimmen. Zur Durchführung eines solchen bekannten Verfahrens müssen zwei verschiedene Orte des zu messenden Widerstandes kontaktiert werden. Diese beiden Kontaktierungen erfolgen in einem bevorzugten Ausführungsbeispiel mit zwei verschiedenen Elektronensonden. Der apperative Aufwand ist dabei erheblich.

Der Erfindung liegt die Aufgabe zugrunde, Widerstände und Kapazitäten von elektronischen Bauelementen belastungsfrei zu messen.

Diese Aufgabe wird erfindungsgemäss durch ein Verfahren der eingangs genannten Art gelöst, welches die kennzeichnenden Merkmale des Anspruchs 1 aufweist. Mit einem solchen Messverfahren lassen sich wesentlich kleinere Kapazitäten als nach dem Stand der Technik bestimmen. Ausserdem lassen sich mit dem erfindungsgemässen Verfahren Widerstand und Kapazität eines elektronischen Bauelementes auch dann bestimmen, wenn nur ein einziger Auftreffort auf dem elektronischen Bauelement für eine Kontaktierung mit einem Elektronenstrahl zugänglich ist. Da bei dem erfindungsgemässen Verfahren nur eine einzige Kontaktierung erforderlich ist, kann der apparative Aufwand insgesamt sehr gering gehalten werden.

Zum Messen des Potentialverlaufes U(t) wird vorteilhafterweise das in der Elektronenstrahl-Messtechnik übliche Verfahren mit Hilfe eines Sekundärelektronen-Spektrometers angewandt, mit dem zunächst die Potentialänderung am Bauelement gemessen wird, woraus sodann der Potentialverlauf U(t) bestimmt wird.

Als die zur Bestimmung des Widerstandes R und der Kapazität C erforderlichen beiden Messwerte $U(t_1)$, $U(t_2)$ werden zweckmässigerweise die Sättigungsspannung $U_s = U (t \leftrightarrow \infty) \approx U(5RC) = U(t_1)$ und $U_s \cdot 0{,}63 = U(t = RC) = U(t_2)$ herangezogen.

In einer vorteilhaften Ausgestaltung der Erfindung wird bei der Messung an einer Schaltung, z.B. einer integrierten Schaltung, die Frequenz der Elektronenpulse mit der Frequenz des Signals an einem Bauelement, das ein Teil der Schaltung ist, synchronisiert, so dass der Widerstand R und die Kapazität C an diesem Bauelement dynamisch bestimmt werden, woraus dann auf die an dieses Bauelement zugeschaltete Last geschlossen werden kann.

Die Erfindung wird in der Zeichnung näher dargestellt.

Fig. 1 zeigt ein Ersatzschaltbild.

Fig. 2 zeigt die Bestimmung von Widerstand R und Kapazität C aus dem Potentialverlauf U(t).

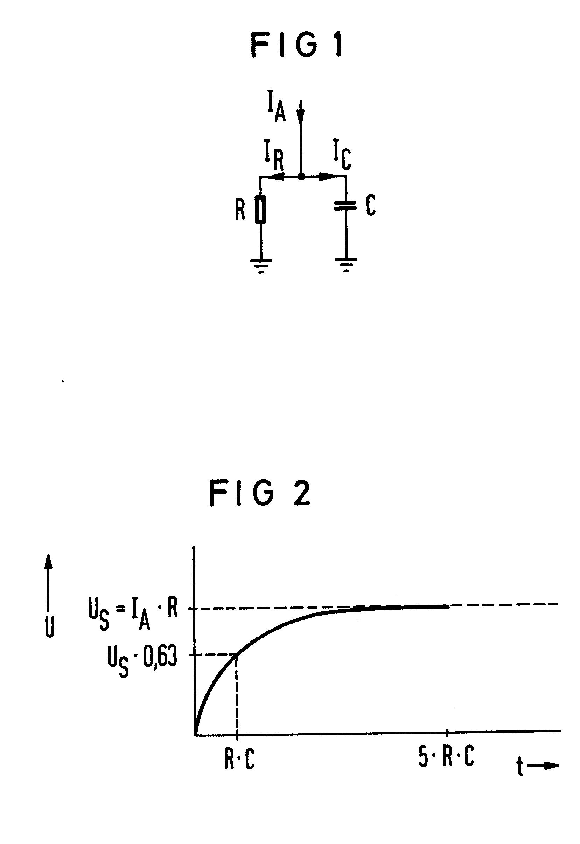

Einem Bauelement mit dem Widerstand R und der Kapazität C wird bei einem erfindungsgemässen Messverfahren durch den Elektronenstrahl ein Strom $I_A$ aufgeprägt gemäss $I_A = I_R + I_C$. Das für dieses Messverfahren von Widerständen und Kapazitäten von elektronischen Bauelementen zutreffende Ersatzschaltbild zeigt Fig. 1.

Für die resultierenden Aufladungen des Bauelementes gilt folgende Differentialgleichung

$$I_A - \frac{U}{R} - \frac{dU}{dt} \cdot C = 0$$

mit der Lösung

$$U = I_A \cdot R \left(1 - e^{-\frac{1}{RC}t}\right).$$

Demnach erreicht die Aufladung des Bauelements für $t \rightarrow \infty$ ($\approx 5 \cdot RC$) eine Sättigungsspannung $U_s$, aus der sich bei bekanntem Strom $I_A$ der Widerstand R berechnen lässt. Die Kapazität C berechnet sich aus der Beziehung $U(t = RC) = U_s \cdot 0{,}63$, wobei für den Widerstand R der aus der Sättigungsspannung $U_s$ gewonnene Widerstandswert R einzusetzen ist. Wenn der Potentialverlauf U (t) experimentell gemessen wurde, so können z.B. der Widerstand R und die Kapazität C vorteilhafterweise grafisch aus dem Potentialverlauf U(t) gewonnen werden, wie in Figur 2 gezeigt wird.

Bei einer Potentialauflösung von 1 mV, einer Zeitauflösung von 5 ns und einem Elektronenstrom $I_A$ von $10^{-7}$ A errechnet sich als Einsatzbereich des Verfahrens

$$R \geq 10\,k\Omega$$
$$C \geq 500\,fF\ (bei\ 10\,k\Omega)$$
$$C \geq 5\,fF\ (bei\ 1\,M\Omega).$$

Für das erfindungsgemässe Messverfahren können Anordnungen herangezogen werden, wie sie z.B. von H.-P. Feuerbaum beschrieben werden in «VLSI testing using the electron probe», SEM/1979/Vol. 1, 285-296, (1979). Für die Messung der Aufladung wird der Elektronenstrom dem elektronischen Bauelement pulsförmig eingeprägt. Die Potentialänderung innerhalb des Pulses wird abgefragt. Dazu wird vorteilhafterweise das in der Elektronenstrahl-Messtechnik übliche Verfahren mit Hilfe eines Sekundärelektronen-Spektrometers verwendet.

Wird z.B. bei der erfindungsgemässen Messung an einer integrierten Schaltung die Frequenz der Elektronenpulse mit der Frequenz des Signals am Messpunkt synchronisiert, so können der Widerstand R und die Kapazität C auch dynamisch bestimmt werden. Aus der Messung des Widerstandes R und der Kapazität C kann dann auf die an das betreffende Bauelement zugeschaltete Last geschlossen werden.

## Patentansprüche

1. Verfahren zur Messung des Widerstands R und der Kapazität C, die an einem Messpunkt eines elektronischen Bauelements gegeben sind, dadurch gekennzeichnet, dass dem Bauelement durch einen gepulsten Elektronenstrahl, der auf dem Messpunkt auftrifft, ein Strom $I_A$ aufgeprägt wird gemäss

$$I_A = U(t)/R + C.dU(t)/dt,$$

und dass der Potentialverlauf U(t), der sich während des Pulses des Elektronenstrahles am Auftreffort dieses Elektronenstrahles auf dem elektronischen Bauelement infolge des aufgeprägten Stromes $I_A$ als Funktion der Zeit t ergibt, gemessen wird, woraus sich durch entsprechende Auswahl von zwei Messwerten $U(t_1)$, $U(t_2)$ des Potentialverlaufes U(t) bei zwei verschiedenen Zeitpunkten $t_1$, $t_2$ bei bekanntem Strom $I_A$ der Widerstand R und die Kapazität C bestimmen lassen.

2. Verfahren nach Anspruch 1, dadurch gekennzeichnet, dass zur Messung des Potentialverlaufes U(t) ein Sekundärelektronen-Spektrometer verwendet wird, mit dem zunächst die Potentialänderung am Messpunkt gemessen wird, woraus sodann der Potentialverlauf U(t) bestimmt wird.

3. Verfahren nach Anspruch 1 oder 2, dadurch gekennzeichnet, dass als die zur Bestimmung des Widerstandes R und der Kapazität C des Bauelementes erforderlichen Messwerte $U(t_1)$, $U(t_2)$ die Sättigungsspannung $U_s = U(t \rightarrow \infty)$ und die Spannung $U_s.0,63 = U(t=RC)$ herangezogen werden.

4. Verfahren nach einem der Ansprüche 1 bis 3, wobei das Bauelement Teil einer Schaltung ist, dadurch gekennzeichnet, dass bei der Messung an dem Bauelement, das Teil der Schaltung ist, die Frequenz der Elektronenpulse mit der Frequenz des Signals am Messpunkt synchronisiert wird, so dass der Widerstand R und die Kapazität C an diesem Bauelement dynamisch bestimmt werden, woraus dann auf die an dieses Bauelement zugeschaltete Last geschlossen wird.

## Claims

1. A method of measuring the resistance R and the capacitance C which occur at a measurement point of an electron component, characterised in that a current $I_A$ is impressed upon the component by means of a pulsed electron beam which hits the measurement point, where:

$$I_A = U(t)/R + C.dU(t)/dt;$$

and that the potential curve U(t) which occurs as a function of the time t during the pulse of the electron beam at the point of impact of this electron beam on the electronic component as a result of the impressed current $I_A$ ist measured, from which, by appropriate selection of two measured values, $U(t_1)$ and $U(t_2)$ of the potential curve U (t) at two different times, $t_1$ and $t_2$, whereby the current $I_A$ being known, the resistance R and the capacitance C can be determined.

2. A method as claimed in Claim 1, characterised in that for the measurement of the potential curve U(t) a secondary electron spectrometer is used, by which the potential change at the measurement point is firstly measured, and from which the potential curve U(t) is then determined.

3. A method as claimed in Claim 1 or 2, characterised in that the saturation voltage:

$$U_s = U(t \rightarrow \infty)$$

and the voltage $U_s.0,63 = U(t=RC)$ are used as the measured values $U(t_1)$ and $U(t_2)$, which are required to determine the resistance R and the capacitance C of the component.

4. A method as claimed in one of Claims 1 to 3, where the component forms part of a circuit, characterised in that in the measurement of the component which forms part of the circuit, the frequency of the electron beam pulses is synchronised with the frequency of the signal across the measurement point so that the resistance R and the capacitance C of this component are dynamically determined, from which the load connected to this component is then determined.

## Revendications

1. Procédé pour mesurer la résistance R et la capacité C au niveau d'un point de mesure d'un composant électronique, caractérisé par le fait qu'on imprime au composant, à l'aide d'un rayon électronique pulsé qui frappe le point de mesure, un courant $I_A$ donné par la relation

$$I_A = U(t)/R + C.dU(t)/dt,$$

et que l'on détermine l'allure du potentiel U (t) qui résulte pendant l'impulsion du rayon électronique au point d'incidence de ce dernier sur le composant électronique, par suite du courant imprimé $I_A$ en fonction du temps (t), pour en déduire, par un choix correspondant de deux valeurs de mesure $U (t_1)$, $U (t_2)$ de l'allure du potentiel U (t), à deux instants distincts $t_1$, $t_2$ et pour un courant $I_A$ connu, la résistance R et la capacité C.

2. Procédé selon la revendication 1, caractérisé par le fait que pour mesurer l'allure du potentiel U (t), on utilise un spectromètre à électrons secondaires avec lequel on mesure d'abord la variation du potentiel au point de mesure, pour en déduire ensuite l'allure du potentiel U (t).

3. Procédé selon la revendication 1 ou 2, caractérisé par le fait qu'on utilise, en tant que valeurs de mesure U $(t_1)$, U$(t_2)$ qui sont nécessaires pour déterminer la résistance R et la capacité C du composant, la tension de saturation $U_s = U(t \to \infty)$ et la tension $U_s.0,63 - U(t = RC)$.

4. Procédé selon l'une des revendications 1 à 3, le composant étant une partie d'un circuit, caractérisé par le fait que lors de la mesure au niveau du composant, qui est une partie constitutive du circuit, la fréquence des impulsions électroniques est synchronisée avec la fréquence du signal au niveau du point de mesure, de manière que la résistance R et la capacité C soient déterminées dynamiquement au niveau de ce composant, la déduction en étant ensuite tirée pour ce qui concerne la charge reliée à ce composant.

# FIG 1

# FIG 2